# EUROPEAN PATENT APPLICATION

(11) **EP 4 832 043 A1**
(43) Date of publication of application: **28.10.2026**
(21) Application number: 24907128.3
(22) Date of filing: 02.12.2024
(51) Int. Cl.: H01J 37/20, G01N 1/28

(54) **SAMPLE HOLDER TIP AND SAMPLE HOLDER**

(30) Priority: 18.12.2023 JP 2023213415
(71) Applicant: Mel-Build Corporation, Fukuoka-shi, Fukuoka 819-0025 (JP)
(72) Inventor: MIYAZAKI, Hiroya, Fukuoka-shi, Fukuoka 819-0025 (JP)
(74) Representative: Studio Torta S.p.A.
(86) International application number: PCT/JP2024/042483
(87) International publication number: WO 2025/134741

(57) **Abstract**

[Problem]

The present invention aims to provide a specimen holder that allows for various types of observation.

[Solution]

The specimen holder tip portion of the present invention comprises a specimen stage for mounting a specimen and/or specimen mesh, a fixing portion for fixing the specimen and/or specimen mesh to the specimen stage, and a voltage application portion for applying a voltage to the specimen, wherein the voltage application portion is mounted on the specimen stage. In a preferred embodiment of the specimen holder tip portion of the present invention, the voltage application portion is integrated with the specimen stage.

## Description

### Technical Field

The present invention relates to a specimen holder tip portion and a specimen holder used for specimen visualization, image formation, analysis, etc., and more particularly to a specimen holder tip portion and a specimen holder used for specimen observation under vacuum.

### Background Art

The need to observe and analyze specimens at the molecular and atomic level has led to the need for electron microscopy, which combines highly accurate imaging and analytical techniques under harsh conditions. For example, transmission electron microscopes (TEMs) are used to observe specimens under ultra-high or high vacuum.

As a specimen holder for positioning a specimen at an observation position of a TEM, for example, a specimen holder for a transmission electron microscope is known, which comprises: a specimen holder body having a first opening with a step formed therein; a specimen holding member that is rotatably housed within the first opening by having a portion of its periphery supported by the step and has a second opening in its center for holding the specimen; and a cover member that has an amorphous material film that covers the second opening except for at least a portion of the second opening (Patent literature 1).

Also known is a cryogenic specimen holder for storing, cooling, and positioning a specimen in at least one imaging and analysis device, characterized in that it includes a container for storing and holding the specimen, a storage container for storing a liquid cooling medium having a collection point for the liquid cooling medium, a thermal conductor that is in thermal contact with the liquid cooling medium and the container regardless of the amount of the liquid cooling medium in the container and the spatial orientation of the storage container, the thermal conductor being in adjacent surface contact with the liquid cooling medium at the collection point, and an elongated barrel attached between the storage container and the container to position the specimen at a preselected location in at least one of the imaging and analysis devices (Patent literature 2).

### Prior art literature

### Patent literature

Patent Literature 1 : JP-A-2007-179805
Patent Literature 2 : JP-A-2013-537689

### Summary of Invention

### Problems to be resolved by the invention

Conventional TEM specimen holders, including the one described in Patent literature 1, require the separation of the atmosphere and vacuum sides to prevent vacuum leakage through the holder within the TEM. Because observations with a transmission electron microscope are performed under high vacuum (high vacuum is preferred), it is necessary to locate the vacuum/atmosphere partition (sealing surface) as close to the tip of the holder as possible to minimize the volume or surface area to be evacuated. This results in spatial constraints on the design, as the specimen holder tip shaft either has a small diameter or the inner diameter is reduced due to the presence of a sealing member (e.g., an O-ring).

Furthermore, in recent years, as we strive for a decarbonized society, the shift to electric vehicles is progressing worldwide, and research and development into lithium-ion batteries is being conducted accordingly. Until now, due to various physical factors, it has been difficult to observe lithium-ion batteries under an electron microscope, and even leading companies both in Japan and overseas have been unable to achieve this.

Although a battery needs electricity to operate, as mentioned above, it was difficult to even observe a battery with an electron microscope, and it was even more difficult to pass electricity through it.

As described above, improvements in analytical technology and analytical demands have led to the need for specimen observation under a variety of conditions and environments. However, to meet these demands, sufficient space is required within the specimen holder, but in the past, it was difficult to secure sufficient space due to the aforementioned common sense in design.

In order to solve the above problems, an object of the present invention is to provide a specimen holder that allows various observations.

### Means of solving the problems

In order to achieve the above object, the present inventors have conducted extensive research into the degree of freedom in designing a device that can ensure a high vacuum, and as a result have come up with the present invention.

In other words, a specimen holder tip portion of the present invention is characterized by comprising: a specimen stage for mounting a specimen and/or specimen mesh; a fixing portion for fixing the specimen and/or specimen mesh to the specimen stage; and a voltage application portion for applying a voltage to the specimen, wherein the voltage application portion is mounted on the specimen stage.

Further, in a preferred embodiment of the specimen holder tip portion of the present invention, it is characterized in that the voltage application portion is integrated with the specimen stage.

Further, in a preferred embodiment of the specimen holder tip portion of the present invention, it is characterized in that the specimen and/or specimen mesh is mounted on the specimen stage via a chip or a cartridge.

Further, in a preferred embodiment of the specimen holder tip portion of the present invention, it is characterized in that the chip or the cartridge has electrode terminals.

Further, in a preferred embodiment of the specimen holder tip portion of the present invention, it is further characterized by having a sealing portion located in the direction of the electron microscope axis center more than the specimen stage.

Further, in a preferred embodiment of the specimen holder tip portion of the present invention, it is further characterized by having an offset cam mechanism.

Further, the specimen holder of the present invention is characterized by having the specimen holder tip portion of the present invention.

Furthermore, the specimen holder of the present invention is characterized by comprising: a specimen holder shaft portion having the specimen holder tip portion described in any one of claims 1 to 6; an outer cylinder portion capable of housing the specimen holder shaft portion; a specimen holder handle portion installed on the specimen holder shaft portion opposite to the specimen holder tip portion; and a support portion for passing at least an electrode or a flow path, located at a position outward from the center of the goniometer stage position of the electron microscope when the specimen holder is installed in an electron microscope.

Furthermore, in a preferred embodiment of the specimen holder of the present invention, it is characterized in that the specimen holder shaft portion has a groove.

Furthermore, in a preferred embodiment of the specimen holder of the present invention, it is characterized in that the specimen holder tip portion can be stored in the outer cylinder portion.

Furthermore, in a preferred embodiment of the specimen holder of the present invention, it is further characterized by having a cooling portion capable of cooling the specimen holder shaft portion.

Furthermore, in a preferred embodiment of the specimen holder of the present invention, it is characterized in that, when the specimen holder is installed in an electron microscope, it has a partition member that separates the inside of the outer cylinder portion from the atmosphere, located at a position outward from the center of the goniometer stage position of the electron microscope.

Furthermore, in a preferred embodiment of the specimen holder of the present invention, it is characterized in that the partition member is installed at the connection portion between the outer cylinder portion and the specimen holder handle portion.

Furthermore, in a preferred embodiment of the specimen holder of the present invention, it is characterized in that the specimen holder shaft portion is rotatable about the specimen holder shaft.

Furthermore, in a preferred embodiment of the specimen holder of the present invention, it is characterized in that, by the rotation, the specimen is rotatable around the axis of the specimen holder shaft portion, or rotatable around an axis perpendicular to the axial direction of the specimen holder shaft portion.

### Effect of Invention

The specimen holder tip portion of the present invention has the advantage that, since the voltage application portion (unit) is mounted on the specimen stage, for example, in inclined observation of a specimen, the electrode probe does not slip with the inclination, and there are no problems such as the image of the specimen shaking due to vibration. Furthermore, the specimen holder of the present invention has the advantage that it is possible to isolate the specimen and/or the specimen mesh mounting portion (unit) from the atmosphere during transport, and thus functions as a transfer holder. Furthermore, the specimen holder of the present invention has the advantage that it is possible to evacuate the specimen holder using the vacuum evacuation from the electron microscope side.

### Brief description of the drawings

[Figure 1]

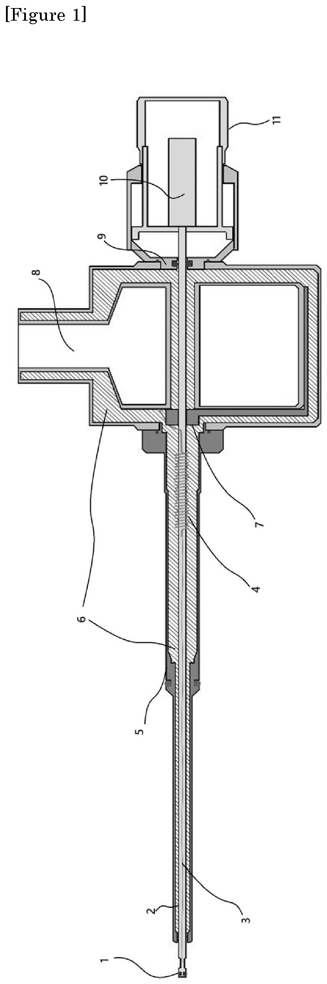

   Figure 1 is a figure showing a lateral cross-sectional view of a specimen holder in one embodiment of the present invention.
[Figure 2]

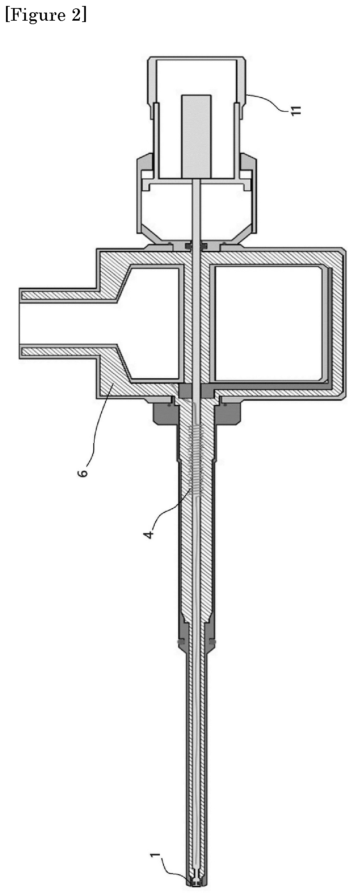

   Figure 2 is a figure showing a lateral cross-sectional view of a specimen holder in one embodiment of the present invention (when the specimen holder tip portion is retracted).
[Figure 3]

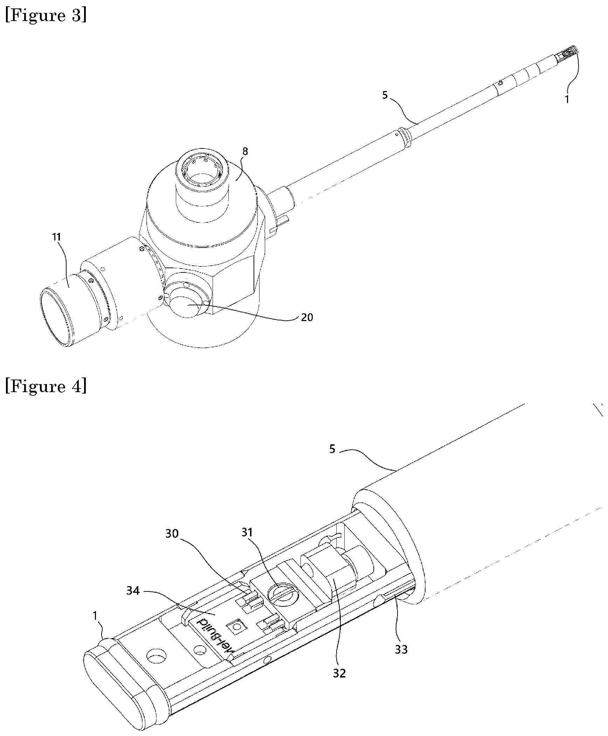

   Figure 3 is a figure showing a perspective view of a specimen holder in one embodiment of the present invention.
[Figure 4]
   Figure 4 is a figure showing a perspective view of the specimen holder tip portion in one embodiment of the present invention.
[Figure 5]

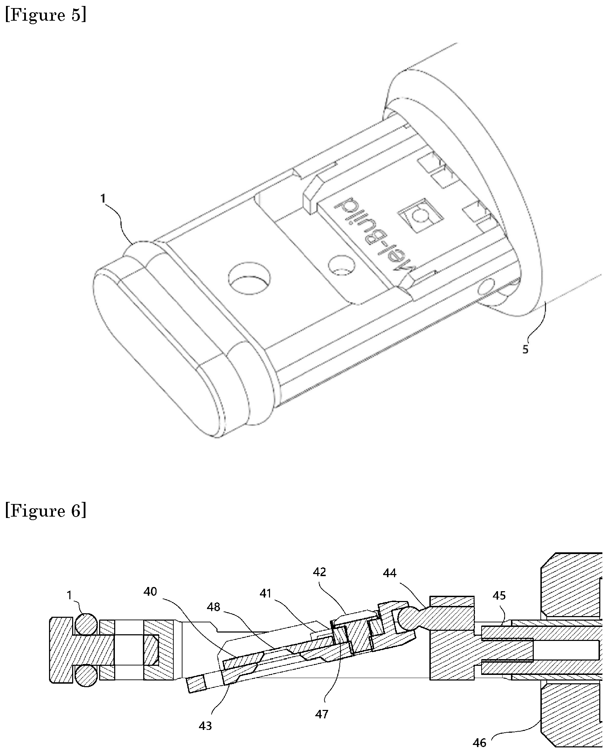

   Figure 5 is a figure showing a perspective view of the specimen holder tip portion in one embodiment of the present invention. It shows the specimen holder tip portion in a retracted position in one example.
[Figure 6]
   Figure 6 is a figure showing a lateral cross-sectional view of the specimen holder tip portion in one embodiment of the present invention.
[Figure 7]

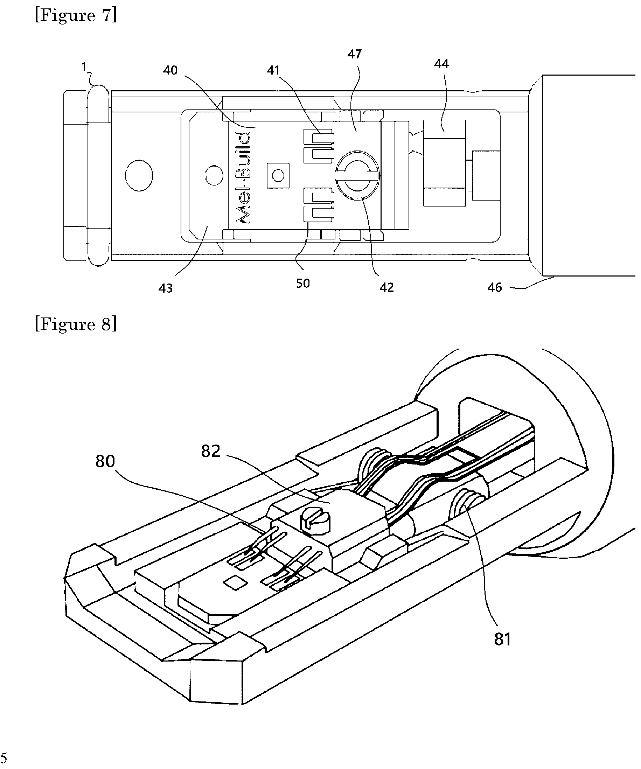

   Figure 7 is a figure showing a top view of the specimen holder tip portion in one embodiment of the present invention.
[Figure 8]
   Figure 8 is a figure showing a perspective view of a conventional specimen holder tip portion.
[Figure 9]

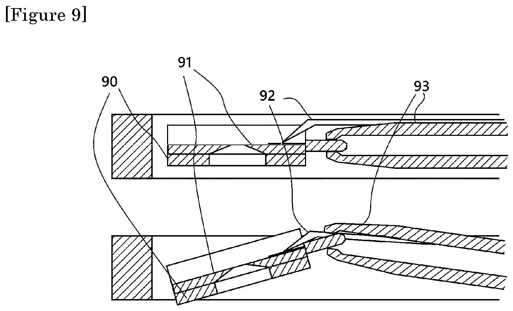

   Figure 9 is a figure showing a lateral cross-sectional view of a conventional specimen holder tip portion.

### Mode for Carrying Out the Invention

The specimen holder tip portion of the present invention is characterized by comprising: a specimen stage for mounting a specimen and/or specimen mesh; a fixing portion for fixing the specimen and/or specimen mesh to the specimen stage; and a voltage application portion for applying a voltage to the specimen, wherein the voltage application portion is mounted on the specimen stage. In the present invention, the specimen stage on which a specimen and/or specimen mesh is mounted is not particularly limited, and may be a specimen stage on which only a specimen is mounted. The fixing portion for fixing the specimen and/or specimen mesh to the specimen stage is also not particularly limited, and may be any part that can fix the specimen and/or specimen mesh to the specimen holder tip portion. As described later, when transporting specimens using chips or cartridges, the specimens may be fixed using such tips. The voltage application portion (unit) is designed to allow observation of specimens even when they are energized, in response to the current demand for specimen observation under various conditions and environments. Since the voltage application portion is mounted on the specimen stage on which the specimen is also placed, it is possible to minimize image shaking and other issues that occur in conventional systems, as will be described later.

Furthermore, in a preferred embodiment of the specimen holder tip portion of the present invention, it is characterized in that the voltage application portion is integrated with the specimen stage.

Conventional voltage application units are not mounted on the specimen stage but are installed in a device that is driven separately from the specimen stage. For example, existing two-axis tilting current holders have a spring 81 for tilting, and the tilt of the specimen base 90 (cradle) and the electrodes exist separately (see Figures 8 and 9). Therefore, the electrodes and the chip 91 (commonly known as a MEMS chip) for applying electricity are provided separately from the tilting mechanism, and as it tilts, the electrode probes 80 and 92 (needles) slide over the electrodes. In other words, because the rotating cradle 90 and the electrodes are separate, when the cradle 90 tilts, the position of the electrode probes 92 shifts, which transmits vibrations, resulting in the problem of image shaking when tilted. Furthermore, since the spring 81 is the mechanism for returning the tilt to its original position, the placement of the spring 81 requires the use of the entire shaft diameter of the narrow holder. Moreover, because it is driven separately from the electrode, it is impossible to add an atmospheric shielding function, i.e., a retract function. Furthermore, because the chip 91 and the electrode probe 92 are driven separately, it is virtually impossible to have a structure that does not expose the device to the atmosphere. In the past, there were various problems, but surprisingly, in the present invention, since the voltage application portion (unit) is mounted on the specimen stage in addition to the specimen, the problem of image shaking is not only solved, but compactness is achieved, and consequently, the specimen holder tip portion can also be retracted, thus achieving the function of not exposing the device to the atmosphere.

Furthermore, in a preferred embodiment of the specimen holder tip portion of the present invention, it is characterized in that the specimen and/or specimen mesh is mounted on the specimen stage via a chip or a cartridge. The specimen can be placed on the chip or cartridge, and the chip or cartridge can be fixed to the specimen stage.

Furthermore, in a preferred embodiment of the specimen holder tip portion of the present invention, it is characterized in that the chip or the cartridge has electrode terminals. In the present invention, since the voltage application portion is located on the specimen stage, the electrode from the voltage application portion and the electrode terminal from the chip or cartridge can be brought into contact to conduct electricity. At this time, the electrode terminals can be used to fix the chip or the like to the specimen stage, and by extension, to fix the specimen to the specimen stage.

Furthermore, in a preferred embodiment of the specimen holder tip portion of the present invention, it is further characterized by having a sealing portion located in the direction of the electron microscope axis center more than the specimen stage. By installing the sealing portion, as will be described later, when using the vacuum evacuation on the electron microscope side during specimen observation, the vacuum of the specimen holder can be evacuated without becoming an obstacle, and when transporting the specimen holder, the inside of the specimen holder can be sealed off from the outside air, etc. when the specimen holder tip portion is stored, thus providing the advantageous effect of being usable as a transfer holder. As will be described later, it is also possible to install a sealing portion on the outer cylinder portion of the specimen holder closer to the center of the electron microscope as a sealing portion that serves a similar role. The above-mentioned atmospheric exposure function can be achieved if there is a sealing portion on at least one of the specimen holder tip portion or the outer cylinder portion.

In the invention, the specimen and voltage application portion can be mounted on the specimen stage, thus achieving a compact design. If the TEM holder is large and there is sufficient space inside the electron microscope, there is no problem with storage. However, for example, if a spring type is used as in the conventional design described above, the specimen holder becomes large in the longitudinal direction and on both sides, and the inclined structure becomes complex, making it very difficult to use the tip of the holder as a storage axis. In addition, when storing the tip, it is necessary to create a sealing surface to prevent exposure to the atmosphere and for vacuum transfer, but with existing technology, it is necessary to arrange springs or the like, which presents the problem that it is physically difficult to store it on the axis of a thin TEM holder.

Furthermore, if the specimen holder shaft is large, it is not impossible to create a chamber in the holder handle portion to accommodate the entire shaft of the conventional air-free mechanism holder, but this would eliminate the function of storing only the tip. Storing the entire shaft, including the specimen holder handle portion, would more than double the total length of the holder when stored, resulting in poor usability, vibration, and drawbacks such as leakage phenomena that break the vacuum and reduced reliability of the storage seal. In addition, it would no longer fit in a typical glove box, and it would be impossible to achieve air-free operation with FEI (using a thin shaft like current Thermo Fisher). However, in the invention, because the specimen and voltage application portion can be mounted on the specimen stage, it is possible to reduce the space required for the electrode-equipped specimen base and tip portion, and the invention aims to achieve storage even on a holder shaft with a thin shaft diameter, specifically φ7 mm.

Furthermore, in a preferred embodiment of the specimen holder tip portion of the present invention, it is characterized by further having an offset cam mechanism. In the present invention, the offset cam mechanism is not particularly limited, and any conventional method can be used. The specimen holder tip portion of the present invention is equipped with a camshaft, and by rotating the specimen holder shaft, the camshaft also rotates, and the specimen stage can be tilted. By rotating the camshaft, the specimen can be rotated around an axis perpendicular to the axial direction of the specimen holder shaft portion. Note that the rotation of the specimen holder shaft portion can also be performed by rotating the handle portion.

Furthermore, the specimen holder of the present invention is characterized by having the specimen holder tip portion of the present invention. For specimen holder tip portions that can be used with the specimen holder of the present invention, refer to the description above.

Furthermore, the specimen holder of the present invention is characterized by comprising: a specimen holder shaft portion having the specimen holder tip portion described in any one of claims 1 to 6; an outer cylinder portion capable of housing the specimen holder shaft portion; a specimen holder handle portion installed on the specimen holder shaft portion opposite to the specimen holder tip portion; and a support portion for passing at least an electrode or a flow path, located at a position outward from the center of the goniometer stage position of the electron microscope when the specimen holder is installed in an electron microscope. For specimen holder tip portions that can be used in the specimen holder of the present invention, refer to the above description.

Furthermore, in the present invention, the sealing portion may be installed on the specimen holder tip portion and/or on the outer cylinder portion. By installing the sealing portion on the specimen holder tip portion and/or on the outer cylinder portion, when observing a specimen, the vacuum evacuation on the electron microscope side can be used without obstruction, and when transporting the specimen holder, the inside of the specimen holder can be sealed off from the outside air, etc., when the specimen holder tip portion is retracted, thus providing the advantageous effect of being usable as a transfer holder.

Furthermore, in the present invention, when the specimen holder is installed in an electron microscope, it may have a support portion that allows at least an electrode or a flow path to pass through, located outward from the center of the goniometer stage position of the electron microscope. In the present invention, the support portion is not particularly limited as long as it is possible to pass at least an electrode or a flow path through it. The support portion can also support the specimen holder shaft portion, and when a cooling portion as described later is used, it can transfer heat from the cooling portion. In addition, when a cooling portion is not required, the support portion can be used in combination with a barrier member as described later.

Furthermore, in a preferred embodiment of the specimen holder of the present invention, it is characterized in that the specimen holder shaft portion has a groove. In the present invention, for example, when applying power, the groove can be cut along the shaft, and wiring can be fixed to the groove and moved in conjunction with the shaft. For example, as will be described later, when storing the specimen holder tip portion, the wiring can be smoothly stored together with the groove.

Furthermore, in a preferred embodiment of the specimen holder of the present invention, it is characterized in that the specimen holder tip portion can be stored in the outer cylinder portion. When the specimen holder tip portion is stored in the outer cylinder portion, the seal present in the specimen holder tip portion and/or the outer cylinder portion can block the outside air from entering the inside of the specimen holder, thereby allowing it to function as a transfer holder. The role of the seal differs from that of conventional seals, even if the location of the seal is similar, in that it does not become an obstacle when using the vacuum evacuation on the side of the electron microscope during specimen observation, and allows for vacuum evacuation of the specimen holder.

In other words, conventionally, due to an overemphasis on vacuum and considerations of polishing techniques, there was a common technical understanding that the seal position had to be placed as close as possible to the front of the specimen holder (towards the center of the microscope). However, conventional technology did not involve the idea of utilizing the vacuum evacuation from the electron microscope side. Therefore, in order to minimize the volume to be evacuated, it was assumed that the seal portion should be located as close to the tip of the holder as possible, and that a separate, different vacuum evacuation would be performed from the specimen holder handle side beyond that seal portion.

In conventional technology, the seal is always functioning, making it impossible to utilize the vacuum evacuation on the electron microscope side. However, in the present invention, when observing a specimen, the specimen holder tip portion is not retracted into the outer cylinder portion, so the seal does not function, allowing the vacuum evacuation on the electron microscope side to be utilized. At the same time, when the specimen holder tip portion is retracted, the seal can perform its sealing function, and consequently, it can also be used as a transfer holder.

Furthermore, in a preferred embodiment of the specimen holder of the present invention, it is characterized by further having a cooling portion capable of cooling the specimen holder shaft portion. The position of the cooling portion (unit) is not particularly limited. More specifically, for example, the cooling portion can be positioned in the direction of the handle of the specimen holder, preferably in front of the handle portion. Specifically, the cooling portion can use liquid nitrogen, liquid helium, or the like to cool the specimen holder shaft portion and, consequently, the specimen.

Furthermore, the Dewar vacuum method using an example specimen holder in a preferred embodiment of the present invention makes it possible to create a complete vacuum in a TEM or the like. That is, the vacuuming method of the present invention is characterized by utilizing the vacuum evacuation on the TEM side to create a vacuum.

The vacuum method for the Dewar section of existing cooling holders (specimen holders) is as follows:
1. Heat Zeolite 95 under vacuum for approximately 3 hours. Wait approximately 3 hours for it to return to room temperature.
2. Insert the specimen holder into a TEM or similar device.
3. Place liquid nitrogen into the cooling container.
4. By adding liquid nitrogen, Zeolite 95 adsorbs molecules, increasing the vacuum level of the Dewar section, thereby providing vacuum insulation and cooling.

However, the problems with existing vacuum maintenance methods for Dewar sections are as follows:
1. The adsorption capacity of the zeolite gradually decreases with cooling time. There is a limit to the number of times liquid nitrogen can be refilled.
2. Because the vacuum level is unstable, heat transfer from the outside to the shaft changes over time, and thermal drift is unstable. Therefore, it is difficult to acquire data at high resolution (atomic resolution) using TEM, etc., due to thermal drift.
3. Furthermore, vacuum insulation is required between the TEM side and the Dewar side, necessitating a sealing component. However, heat flows into the shaft from this sealing area, contributing to thermal drift. Additionally, the heat input prolongs the cooling time and increases the target temperature.
4. Since the zeolite's adsorption capacity becomes saturated, vacuum heating of the zeolite is required after observation, requiring approximately 6 hours between the end of observation and the next step.

In contrast, as described above, the Dewar vacuum method using one example of the specimen holder in the present invention makes it possible to create a complete vacuum using a TEM or the like. That is, the vacuuming method of the present invention is a method of creating a vacuum in an electron microscope using the specimen holder of the present invention, and is characterized by using the vacuum evacuation on the electron microscope side to create the vacuum.

In other words, the advantages of the vacuum method using the specimen holder of this example are as follows: 1. There is no need to use a sealing part, and there is no need to evacuate the cooling side and the specimen holder tip side separately, and as a result, the same vacuum level can be maintained throughout, so there is no influence from uneven radiant heat (heat from the external environment). (The radiant heat becomes uniform throughout.)
2. Because there is no sealing part in between, the heat input from the device side such as TEM is very small.
3. Due to the advantages mentioned above, the temperature stability performance of the heat-transmitting axis is significantly improved, and the effects of thermal drift are reduced. This vacuum method reduces the effects of heat input and radiant heat on the specimen holder, allowing for stable acquisition of high-resolution images even during cooling.
4. Supplementary effect: Since the entire vacuum is created in TEM, etc., the pre-preparation of superheating and vacuuming the zeolite becomes unnecessary. With the specimen holder of the invention, cooling can be performed immediately after returning to room temperature, allowing for observation multiple times a day.

In the present invention, in more precise, the absence of the seal means that, when observing the specimen, the specimen holder tip portion is not housed in the outer cylinder portion of the specimen holder, and the seal that separates the inside and outside of the specimen holder does not function; in other words, it is not sealed, and it is possible to create a vacuum throughout the inside of the specimen holder using a TEM or the like. When using the vacuum evacuation on the electron microscope side during specimen observation, a seal (also called a second seal or barrier member) is ultimately installed in front of the handle portion, or between the casing of the cooling dewer and the storage handle portion, to seal the motor connecting shaft. This allows the inside of the specimen holder to be vacuumed using the vacuum on the electron microscope side while being isolated from the outside air. Alternatively, the seal portion may be provided between the holder shaft and the casing of the cooling dewer. While it is characteristic to place it on the outside of the holder shaft, the aforementioned embodiment is preferred.

Furthermore, the material of the sealing portion or the partition wall member described later can be polytetrafluoroethylene or a high-performance fluororubber material such as fluorosilicone. Polytetrafluoroethylene has very high cooling resistance as well as high thermal insulation properties. Therefore, if the sealing portion is made of a material with cooling resistance, observation under cooling conditions can be carried out under conditions of reliable sealing.

Furthermore, in a preferred embodiment of the specimen holder of the present invention, at least one part of the support portion is characterized in that it is capable of transferring heat from the cooling portion to the specimen holder shaft portion. The support portion can be brought into contact with the cooling portion. In this case, heat from the cooling portion can be transferred to the specimen holder shaft portion. In this case, the support portion supports the specimen holder and is also capable of transferring heat from the cooling portion to the specimen holder shaft portion. In the present invention, the material of the support portion when conducting heat is not particularly limited as long as it can efficiently conduct heat, and examples include copper alloys, pure copper, A7075, etc. In addition, copper mixed with (STC) carbon, or any material with good thermal conductivity that can be machined may be used.

Furthermore, the cooling portion may also have a heat conduction portion. For example, when using liquid nitrogen, if a cooling portion is configured and the bottom of the container holding the liquid nitrogen and the specimen holder shaft portion are connected by a heat conduction portion made of a heat-conducting material, the temperature of the liquid nitrogen can be transferred to the specimen holder shaft portion and, consequently, to the specimen until the liquid nitrogen is completely depleted. When a support portion is used in combination, a part of the support portion can act as a heat conduction portion (section), allowing the heat from the cooling portion to be transferred to the specimen holder shaft portion as described above. Thus, according to the embodiment in which the present invention is applied to a cooling holder, the refrigerant in the dewar section can be used up more efficiently, and heat transfer can be stably maintained at a high vacuum, thus providing the advantageous effect of improving temperature stability.

Furthermore, in a preferred embodiment of the specimen holder of the present invention, it is characterized in that, when the specimen holder is installed in an electron microscope, it has a partition member that separates the inside of the outer cylinder portion from the atmosphere, located at a position outward from the center of the goniometer stage position of the electron microscope. In the present invention, positioning the partition member at a position outside the center of the electron microscope, relative to the goniometer stage position of the electron microscope, offers various advantages. That is, conventionally, due to polishing techniques and the like, it was necessary to position the seal as close as possible to the front of the specimen holder (towards the center of the microscope).This is because the inner wall of the specimen holder needs to be polished, but this polishing is difficult, and therefore, in order to polish the minimum surface area, it was conceived to place it closer to the front of the specimen holder (towards the center of the microscope), and in fact, the further away it was, the more likely it was to cause malfunctions of the microscope, specimen holder, and other equipment. Moreover, the partition member is not particularly limited as long as it can block the inside of the outer cylinder portion from the atmosphere. For example, examples of partition members include sealing members and encapsulating materials (sealant), and specifically, examples include O-rings.

Furthermore, in the invention, in a configuration where a seal exists at the specimen holder tip portion for storage, the seal does not serve a purpose during specimen observation and does not hinder the vacuuming of the electron microscope in any way, which is significantly different from the role of conventional seals.

In the present invention, by positioning the partition member at a location outside the center of the electron microscope, relative to the goniometer stage position of the electron microscope, it becomes possible to effectively utilize the internal space between the specimen holder shaft portion and the outer cylinder portion. Conventionally, a barrier member was present in the internal space between the specimen holder shaft portion and the outer cylinder portion, preventing effective utilization of the space.

Furthermore, by positioning the partition member further outward from the center of the electron microscope than the position of the goniometer stage of the electron microscope. as described later, when the barrier member is used in combination with hermetic elements, this makes it possible to effectively utilize a relatively large space located outside the center of the electron microscope, rather than the position of the goniometer stage of the electron microscope. This improves the design flexibility in the present invention and, consequently, improves the performance of the sample holder itself. Specifically in the present invention, it is possible to dramatically improve the performance of sample holders incorporating electrodes, sample holders incorporating flow channels, and cooling sample holders, etc. In other words, in the invention, the large space inside the shaft can be effectively utilized, and the partition member can be positioned in the relatively large space on the outside. This allows for greater design flexibility by utilizing the space around the partition member, and also significantly improves the ease of wiring and other tasks.

In other words, conventionally, due to an overemphasis on vacuum and considerations related to polishing techniques, there was a common technical understanding that the seal position had to be placed as close as possible to the front of the specimen holder (towards the center of the microscope). However, contrary to this common technical understanding, we have devised a change in thinking and arrived at the present invention.

Furthermore, the specimen holder to which the present invention can be applied is not particularly limited. For example, it can be applied to single-axis tilt specimen holders, bi-axis tilt specimen holders, electric field holders, magnetic field holders, heating holders, or so-called cooling specimen holders having a cooling portion, and may also be a cooling holder with a bi-axis tilt mechanism.

Furthermore, in a preferred embodiment of the present invention, the outer wall surface of the specimen holder shaft portion and the inner wall surface of the outer cylinder portion can be mirror-finished. The outer wall surface of the specimen holder shaft portion and the inner wall surface of the outer cylinder portion can be mirror-finished, and by adopting such a configuration, the advantages described later in so-called "vacuum drawing" can be obtained.

Mirror finishing can be performed using various methods, such as buffing, hand polishing, other polishing methods, or combinations of multiple polishing methods, depending on the shape and specifications of the specimen holder components. Preferably, the mirror finish includes fine areas that were not previously targeted, such as internal steps, bored sections, screw hole sections, and groove sections. The surface roughness achieved by the mirror finish can preferably be in the range of 0.2 µm to 1 µm, and more preferably not exceeding 0.2 µm, in terms of arithmetic mean roughness Ra value. Polishing the inside of the holder shaft to a mirror finish in this way has the advantageous effect of enabling the achievement of the specified high vacuum value without placing an excessive load on the TEM's vacuum evacuation system.

In a preferred embodiment of the present invention, the partition member may be installed at the connection between the outer cylinder portion and the specimen holder handle. The partition member is not particularly limited as long as it can be positioned outward from the center of the electron microscope relative to the goniometer stage position of the electron microscope, but by installing it at the connection, it is possible to secure more space inside the shaft and space for the handle.

Furthermore, in a preferred embodiment of the present invention, the partition member may be installed inside the specimen holder handle portion. In this case, there are virtually no spatial constraints on the hermetic portion, allowing for a wider and larger design. Hermetic generally refers to an airtight sealing structure that blocks outside air, but in the present invention, it is interpreted more broadly and can be used as a support member for passing electrodes, fluid channels, etc. The partition member may also serve as a hermetic structure through which at least electrical wiring members or fluid piping passes. As a hermetic structure, depending on the usage conditions of the specimen holder corresponding to the observation conditions of the specimen (heating, fluid inflow, application of an electric field, light/laser irradiation, and combinations thereof), it was previously almost impossible, but in the present invention, it is possible to pass a total of eight or more wires, including electrical wiring members and fluid piping, through the hermetic structure.

Furthermore, in a preferred embodiment, the specimen holder shaft portion can be made rotatable around the specimen holder shaft. This is also called X-axis tilt, α-tilt, or uniaxial tilt. Generally, this can be done using the TEM device side, but in the present invention, X-axis tilt is also possible on the specimen holder side. By making the specimen holder rotatable around the specimen holder shaft, the specimen and/or specimen mesh mounting portion can also be made rotatable around the specimen holder shaft, enabling observation of the specimen and/or other components in a rotated state. The rotation may be done by conventional methods and is not particularly limited. More specifically, for example, the rotation may be performed using the handle portion of the specimen holder.

Furthermore, in a preferred embodiment of the present invention, the rotation allows the specimen and/or specimen mesh mounting portion to be rotatable around the axis of the specimen holder shaft as described above, as well as around an axis perpendicular to the axial direction of the specimen holder shaft portion. The mechanism for rotation around the axis perpendicular to the axial direction of the specimen holder shaft may be a conventional method and is not particularly limited. In a preferred embodiment, the rotation around the axis perpendicular to the axial direction of the specimen holder shaft may be performed via an offset cam mechanism.

Furthermore, even when the specimen holder is for cooling purposes, the position of the partition member is not particularly limited. The partition member can be installed at any of the following locations: the connection point between the cooling portion (dewar portion) and the handle portion; near the connection portion between the cooling portion and the outer cylinder portion on the microscope's central side; or at the bottom section, middle section, or top section of the dewar portion.

Furthermore, by incorporating a MEMS (Micro Electro Mechani System) chip, it becomes possible to perform observations of the specimen under conditions such as heating, electrical current application, and tensile strength, each without exposure to air and under cooling. This makes it possible to control and observe basic physical quantities with a single holder. Moreover, a MEMS (Micro Electro Mechani System) chip is an abbreviation for micro-electromechanical system, and is a general term for devices in which mechanical elements such as sensors, actuators, and heaters are integrated into a minute area on a semiconductor substrate such as silicon or a glass substrate using microfabrication technology. Conventional methods can be incorporated into the invention, and it is not particularly limited. Electrical circuits and mechanical structures are incorporated within a micron-sized region, and particularly in the field of electron microscopy, under constraints such as small spaces and high vacuum, this method is effective for reproducibly controlling physical parameters such as current flow, heating, and stress application on test specimens ranging from a few micrometers to a few millimeters. This method can also be applied to the present invention by conventional means.

Furthermore, in the case of heating, the chip can be heated by fabricating a heater pattern on the chip and passing an electric current through it. The heater pattern can be made using conventional methods and is not particularly limited; for example, spiral, wave, or honeycomb patterns can be possible. Ideally, the heater pattern should be one that cancels out the magnetic field generated by the current, or one that heats evenly.

Furthermore, when applying current, by creating electrode (positive and negative) patterns on both sides of a space such as a slit, and then placing the specimen across the slit (any suitable space will do) and applying a voltage, it is possible to apply a voltage between the power sources or to allow current to flow through the electrodes.

Furthermore, in the case of tension, tensile stress can be applied to a specimen by creating an actuator that operates by applying electricity, which is patterned into a chip shape.

### Example

The following describes embodiments of the specimen holder of the present invention with reference to the drawings, but the present invention is not limited to these embodiments. Furthermore, it goes without saying that the invention can be modified as appropriate without departing from its spirit.

Figure 1 is a figure showing a lateral cross-sectional view of a specimen holder in one embodiment of the present invention. In Figure 1, 1 is a seal portion, 2 is a specimen holder shaft portion (rotation axis), 3 is a power supply wiring portion, 4 is a power supply wiring extension portion, 5 is an outer cylinder portion, 6 is a vacuum or similar area, 7 is a support portion, 8 is a cooling portion (dewar portion), 9 is a second seal portion, 10 is a motor for shaft tilting, and 11 is a handle portion, respectively. Although not shown, the specimen placement portion is located between the handle portion side of the seal portion 1 and the tip portion of the outer cylinder portion 5 on the electron microscope side. Alternatively, the specimen placement portion may be a specimen mesh placement portion, or a combination of a specimen placement portion and a specimen mesh placement portion is also possible. When the tip portion of the specimen holder is stored, in the power supply wiring extension portion 4, the spring-shaped power supply wiring extension portion 4 can extend and retract.

Figure 1 is a schematic diagram of the specimen during observation. When the specimen holder is set in the electron microscope, the same vacuum region 6 as the TEM vacuum can be achieved by utilizing the vacuum evacuation from the electron microscope side (TEM). That is, for example, as shown in the figure, the second seal portion 9 can be installed outside the gonioscope of the electron microscope, and when utilizing the vacuum evacuation from the electron microscope side (TEM), the vacuum region 6 can be made the same as the TEM vacuum. The second seal portion (also called a barrier member) may be, for example, directly in front of the handle portion 5 or inside the handle portion 5. On the other hand, as the seal position moves closer to the handle portion 11 from the outer cylinder portion 5, the space becomes larger, which increases the so-called vacuum volume and puts a load on the TEM's vacuum exhaust system. In other words, in the conventional configuration where the seal member is installed at the tip, simply moving the seal position closer to the handle portion makes it increasingly difficult to achieve the specified value with vacuum. However, this can be addressed by polishing the inside of the holder shaft to a mirror finish to the extent that it does not cause problems with vacuum. More details on the mirror finish will be described later.

Moreover, in the examples of the present invention, liquid nitrogen is used as an example of the refrigerant in the container of the cooling portion (dewar unit) 8.

Furthermore, in a configuration that allows for cooling, a cooled refrigerant can be used. For example, when using liquid nitrogen, if a normal O-ring is used in the usual way, the O-ring will solidify at the liquid nitrogen temperature, and the metal will shrink as the temperature drops. Therefore, vacuum sealing (external sealing) becomes impossible in a specimen holder that uses liquid nitrogen.

However, if a cold-resistant material such as polytetrafluoroethylene is used as a sealing material, the polytetrafluoroethylene - made sealing material will have excellent sealing performance even under liquid nitrogen conditions because it can withstand temperatures down to -200°C or below.

Figure 2 shows a lateral cross-sectional view of a specimen holder in one embodiment of the present invention. In Figure 2, 1 is the seal portion, 4 is the extension portion for power supply wiring, 6 is the vacuum or similar area, and 11 is the handle portion, respectively. Figure 2 shows the case where the specimen holder tip portion containing the specimen is stored inside the outer cylinder portion of the specimen holder. By storing the specimen holder tip portion, the region of the vacuum or similar area 6 can be maintained in argon or vacuum, and vacuum transfer is also possible. The handle portion 11 can be moved parallel to the longitudinal direction of the specimen holder, as shown in Figures 1 and 2, thereby allowing the specimen holder tip portion to be stored together with the wiring. In this way, the inside of the Dewer and the TEM holder can be kept under the same vacuum, and as will be described later, it is also possible to place a feedthrough in the Dewer portion, making it possible to achieve power supply, cooling, biaxial tilting, and air exposure prevention with a single specimen holder.

Figure 3 is a figure showing a perspective view of a specimen holder in one embodiment of the present invention. In Figure 3, 1 is the seal portion, 5 is the outer cylinder portion, 8 is the cooling portion (dewar portion), 11 is the handle portion, and 20 is the feed-through portion, respectively. Figure 3 shows the case where the specimen holder tip portion is not retracted, and the seal portion 1 is visible. In this embodiment, the Dewar side can have a feed-through portion for wiring. In this embodiment, it is also possible to place an electrode at the tip while maintaining the retraction function, i.e., the function of not being exposed to the atmosphere. In this case, the structure of the electrode is not particularly limited.

Moreover, in this example, the field-through portion (hermetic) is provided on the cooling portion side, but the second seal portion and/or field-through portion may be installed at the connection portion between the outer cylinder portion and the specimen holder handle portion. In this case, the specimen holder shaft portion (rotating shaft) and the conductor can be hermetically passed through. Depending on the operating conditions of the specimen holder (heating, fluid inflow, application of an electric field, light/laser irradiation, or a combination thereof), the number of components that pass through the hermetic can be multiple.

Furthermore, although not shown in the diagram, a sealing surface including a second sealing portion may be provided further inside the handle portion. The second sealing portion may also become part of the hermetic structure. In this example, by placing the sealing surface in a wider space outside the gonioscope of the electron microscope, the hermetic structure is virtually free from spatial constraints, allowing for a wide and large design. When introducing a fluid (gas, liquid) into the inside of the holder, pipes or the like may be incorporated as flow paths, but with the structure of this example, it is possible to design it easily without worrying much about interference between the flow path and/or electrodes and related components.

On the other hand, as the sealing surface is moved further back from the center of the electron microscope outside the gonioscope, the volume of vacuum drawn by the electron microscope increases, which can put a load on the electron microscope's vacuum evacuation system.

In such cases, high vacuum can be achieved by polishing the inside of the holder shaft portion to a mirror finish over as wide an area as possible. In this case, it is preferable that at least the inner surface of the outer cylinder portion be mirror-finished. Furthermore, the area of mirror finishing should include fine areas that were not conventionally targeted, such as internal steps, and the smaller the area that is not mirror-finished, the better.

Furthermore, the mirror finish may be achieved by buffing, hand polishing, other polishing methods, or a combination of multiple polishing methods, depending on the shape and specifications of the specimen holder components. Moreover, it is also preferable that the surface roughness achieved by the mirror finish does not exceed 0.2 µm in arithmetic mean roughness Ra. If Ra exceeds 1, it becomes practically difficult to maintain vacuum in the dewar section using the TEM's vacuum evacuation system. In other words, if Ra exceeds 1, it will take a long time to maintain vacuum in the dewar section using the TEM's vacuum evacuation system, which may cause practical inconvenience.

Next, it will be described an embodiment in which the specimen holder of the present invention is used in a TEM to perform so-called vacuum evacuation. In particular, it will be described an example in which the specimen holder of the present invention is used as a cooling specimen. When the Dewar vacuum method is performed in the specimen holder of the present invention, the area covered by the vacuum is as shown in region 6 of Figure 1. That is, the area covered by the vacuum in the specimen holder of the present invention extends as shown in region 6 of Figures 1 and 2. In the specimen holder, when the entire vacuum is performed with a TEM, it is possible to maintain a practically uniform vacuum level in the entire region from inside the Dewar housing to the shaft portion and outer cylinder portion, so there is no influence from uneven radiant heat on the specimen holder. In other words, the radiant heat received by the specimen holder becomes virtually uniform. Furthermore, because there is no sealing portion within the outer cylinder portion as in the conventional technology, the heat input to the specimen holder 10 from devices such as TEM can be greatly reduced. Moreover, the heating and vacuuming of the zeolam, which was a preparatory step in the conventional technology, is unnecessary in the specimen holder of the present invention.

Furthermore, when the specimen holder of the present invention is used for cooling, the inside of the dewar can be brought to the vacuum level of a microscope, which not only improves the retention of liquid nitrogen, but also, in an embodiment in which a heat conductive member is installed between the specimen holder shaft portion and the cooling unit, the heat conductive member can also be stably maintained at a high vacuum, thereby improving temperature stability.

Next, Figure 4 is a figure showing a perspective view of the tip of a specimen holder in one embodiment of the present invention. In Figure 4, 1 is the seal portion, 5 is the outer cylinder portion, 30 is the electrode, 31 is the electrode fixing screw, 32 is the two-axis tilting cam structure, 33 is the groove, and 34 is the chip, respectively. In the present invention, the chip or cartridge 34 can be used to install the specimen on the specimen mounting stage at the specimen holder tip portion. It is also possible to fix the chip 34 using the electrode 30. The electrode 30 may be fixed to the specimen mounting stage by the electrode fixing screw 31. In this example, a two-axis tilting cam structure 32 can also be provided, and the specimen can be tilted in two axes using the specimen holder shaft portion, handle portion, etc. Furthermore, the groove 33 is cut from the side of the specimen holder tip portion to the side of the specimen holder shaft portion, allowing wiring to be fixed in the groove, and the wiring etc., at the specimen holder tip portion can be stored together with the specimen holder tip portion. The groove 33 can be installed, for example, up to the power supply wiring extension section 4 in Figure 1. In other words, it is possible to fix the wiring from the specimen holder tip portion to the retract (pull-out shaft (groove)) and store it together with the wiring. This can be achieved by drawing a vacuum up to the Dewer.

Figure 5 is a figure showing a perspective view of the tip of a specimen holder in one embodiment of the present invention. It shows how the specimen holder tip portion is stored in one example. In Figure 5, 1 indicates the seal portion and 5 indicates the outer cylinder portion, respectively. In the figure, an O-ring is placed at the tip, but the O-ring may also be embedded (or placed) inside the front of the outer cylinder portion of the specimen holder.

Figure 6 shows a figure showing a lateral cross-sectional view of the tip of a specimen holder in one embodiment of the present invention. In Figure 6, 1 is the seal portion, 40 is the MEMS chip, 41 is the electrode, 42 is the fixing portion (fixing of the voltage application portion), 43 is the specimen stage, 44 is the camshaft, 45 is the specimen holder shaft (specimen holder shaft portion), 46 is the outer cylinder portion, 47 is the voltage application portion, and 48 is the specimen, respectively. In this example, since the voltage application portion (electrode) and the specimen stage are integrated, the shape allows the specimen holder tip portion to be stored in the outer cylinder portion together with the voltage application portion. This structure can be necessary to accommodate the specimen holder in a minimum diameter of Φ7.

Figure 7 is a figure showing a top view of the specimen holder tip portion in one embodiment of the present invention. In Figure 7, 1 is a seal portion, 40 is a MEMS chip, 41 is an electrode, 42 is a fixing part (for fixing the voltage application part), 43 is a specimen stage, 44 is a camshaft, 46 is an outer cylinder portion, 47 is a voltage application part, and 50 is an electrode terminal. In this example, since the voltage application part 47 is located on the specimen stage 43, the electrode 41 from the voltage application part 47 and the electrode terminal 50 from the chip or cartridge 40 can be brought into contact and current can be supplied. At this time, the electrode terminal 50 can be used to fix the chip or the like 40 to the specimen stage 43, and by extension, to fix the specimen to the specimen stage 43.

Thus, in this invention, it is possible to achieve atmospheric non-exposure while performing cooling and electrical current by making the vacuum of the Dewer and TEM the same. Furthermore, by storing the tip along with the wiring that carries electricity to the shaft that can be stored from the specimen base with electrodes attached, it is possible to realize an atmospheric non-exposure cooling holder in which the tip can be stored and which can be cooled with liquid nitrogen. In other words, in the invention, by making the vacuum of the Dewer and the vacuum of the TEM the same, the difference in the effect of radiant heat when cooling is eliminated, so that thermal drift due to cooling can be stopped, and when controlling the temperature there is no difference in the effect of radiant heat, more advanced temperature control is possible and it becomes possible to stop thermal expansion at the nano level.

In the invention, by observing changes in a substance caused by heating, applying an electric field, or passing an electric current near (directly below) the specimen using a transmission electron microscope, it is possible to clarify the phase transformation, changes in atomic positions, and electrochemical behavior at the microscopic level. Furthermore, by blowing gas near the specimen or flowing a fluid such as gas into a space separated from the vacuum, electron microscope observation in a near-realistic environment becomes possible.

As described above, the specimen holder of the present invention makes design, wiring and assembly work, and maintenance dramatically easier by bringing the sealing part (and/or hermetic) closer to the handle portion, that is, to a large open area.

Furthermore, in the specimen holder of the present invention, by mirror-finishing the desired inner surface according to the conditions of the vacuum evacuation system, vacuum evacuation by the TEM's vacuum evacuation system can be maintained, thereby suppressing the frequency of refilling due to the deterioration of the refrigerant's performance and significantly shortening the time until data acquisition for the specimen can be obtained. Therefore, the specimen holder of the present invention can dramatically improve productivity in specimen handling. Moreover, because the mirror-finished inner surface can stably maintain a high vacuum for the heat transfer member, temperature stability can be improved. Thus, the specimen holder of the present invention is expected to make a significant contribution to the development of various research.

### Industrial applicability

The specimen holder of the present invention is suitable for use under high vacuum conditions and is expected to be beneficial in a wide range of fields. The specimen holder of the present invention enables high-precision visualization, image formation, or analysis of specimens under high vacuum conditions, and is expected to make a significant contribution to research advancement.

### Explanation of symbols

1. Seal portion
2. Specimen holder shaft portion (rotating shaft)
3. Power supply wiring
4. Power supply wiring expansion portion
5. Outer cylinder portion
6. Vacuum area, etc.
7. Support portion
8. Cooling portion (Dewar portion)
9. Second seal portion
10. Motor for shaft tilting
11. Handle portion
20. Feed-through portion
30. Electrode
31. Screw for electrode fixing
32. Cam structure for two-axis tilting
33. Groove
34. Chip
40. Chip
41. Electrode
42. Fixing portion
43. Specimen stage
44. Camshaft
45. Specimen holder shaft (specimen holder shaft portion)
46. Outer cylinder portion
47. Voltage application poriton
48. Specimen
50. Electrode terminal
80. Electrode probe
81. Spring
82. Link for driving specimen base
90. Specimen base
91. MEMS chip
92. Electrode probe
93. Link for driving specimen base

## Claims

1. A specimen holder tip portion comprising: a specimen stage for mounting a specimen and/or specimen mesh; a fixing portion for fixing the specimen and/or specimen mesh to the specimen stage; and a voltage application portion for applying a voltage to the specimen, wherein the voltage application portion is mounted on the specimen stage.

2. The specimen holder tip portion according to claim 1, **characterized in that** the voltage application portion is integrated with the specimen stage.

3. The specimen holder tip portion according to claim 1 or 2, **characterized in that** the specimen and/or specimen mesh is mounted on the specimen stage via a chip or a cartridge.

4. The specimen holder tip portion according to claim 3, **characterized in that** the chip or the cartridge has electrode terminals.

5. The specimen holder tip portion according to any one of claims 1 to 4, **characterized by** further having a sealing portion located in the direction of the electron microscope axis center more than the specimen stage.

6. The specimen holder tip portion according to any one of claims 1 to 5, **characterized by** further having an offset cam mechanism.

7. A specimen holder having the specimen holder tip portion according to any one of claims 1 to 6.

8. A specimen holder comprising: a specimen holder shaft portion having the specimen holder tip portion described in any one of claims 1 to 6; an outer cylinder portion capable of housing the specimen holder shaft portion; a specimen holder handle portion installed on the specimen holder shaft portion opposite to the specimen holder tip portion; and a support portion for passing at least an electrode or a flow path, located at a position outward from the center of the goniometer stage position of the electron microscope when the specimen holder is installed in an electron microscope.

9. The specimen holder according to claim 8, **characterized in that** the specimen holder shaft portion has a groove.

10. The specimen holder according to claim 8 or 9, **characterized in that** the specimen holder tip portion can be stored in the outer cylinder portion.

11. The specimen holder according to any one of claims 8 to 10, **characterized by** further having a cooling portion capable of cooling the specimen holder shaft portion.

12. The specimen holder according to any one of claims 8 to 11, **characterized in that**, when the specimen holder is installed in an electron microscope, it has a partition member that separates the inside of the outer cylinder portion from the atmosphere, located at a position outward from the center of the goniometer stage position of the electron microscope.

13. The specimen holder according to claim 12, **characterized in that** the partition member is installed at the connection portion between the outer cylinder portion and the specimen holder handle portion.

14. The specimen holder according to any one of claims 8 to 13, **characterized in that** the specimen holder shaft portion is rotatable about the specimen holder shaft.

15. The specimen holder according to claim 14, **characterized in that**, by the rotation, the specimen is rotatable around the axis of the specimen holder shaft portion, or rotatable around an axis perpendicular to the axial direction of the specimen holder shaft portion.
